(19) Europäisches Patentamt
European Patent Office
Office européen des brevets

(11) EP 0 469 159 B1

# (12) EUROPEAN PATENT SPECIFICATION

(45) Date of publication and mention of the grant of the patent:
**07.01.1998 Bulletin 1998/02**

(21) Application number: **91904463.6**

(22) Date of filing: **14.02.1991**

(51) Int Cl.$^{6}$: **H03H 17/02**

(86) International application number:
**PCT/JP91/00175**

(87) International publication number:
**WO 91/12664 (22.08.1991 Gazette 1991/19)**

## (54) SAMPLING RATE CONVERSION APPARATUS

VORRICHTUNG ZUR KONVERSION EINES ABTASTRATE

APPAREIL DE CONVERSION DE LA CADENCE D'ECHANTILLONNAGE

(84) Designated Contracting States:
**DE FR GB**

(30) Priority: **16.02.1990 JP 35614/90**

(43) Date of publication of application:
**05.02.1992 Bulletin 1992/06**

(73) Proprietor: **SONY CORPORATION**
**Tokyo 141 (JP)**

(72) Inventors:
- **FUJITA, Tadao**
**Shinagawa-ku, Tokyo 141 (JP)**
- **TAKAYAMA, Jun**
**Shinagawa-ku, Tokyo 141 (JP)**
- **NINOMIYA, Ken**
**Shinagawa-ku, Tokyo 141 (JP)**

(74) Representative: **Cotter, Ivan John et al**
**D. YOUNG & CO.**
**21 New Fetter Lane**
**London EC4A 1DA (GB)**

(56) References cited:
**EP-A- 0 305 864**
**DE-A- 3 605 927**
**GB-A- 2 180 114**
**JP-A-58 141 025**
**JP-A-63 282 965**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 469 159 B1

## Description

The present invention relates to a sampling rate converting apparatus.

Hitherto, a sampling rate converting apparatus formed into a digital filter structure has been used for the purpose of sampling an analog signal at a predetermined sampling frequency and converting a digital signal thus-obtained into an arbitrary sampling frequency.

In general, a sampling rate converting apparatus of the type described above is constituted by a high-order oversampling filter for the purpose of strictly securing the Nyquist frequency as the conversion characteristics of its transmission system.

In a case where, for example, the sampling frequency of a 625/50 component digital video signal formed in accordance with the D-1 format for a digital video tape recorder (DVTR) is, by using a sampling rate converting apparatus of the type described above, converted into a sampling frequency, which corresponds to a PAL composite digital video signal formed in accordance with the D-2 format, the sampling frequency cannot directly be converted between the digital video signals because the rate of the sampling frequency is converted from a frequency of 13.5 MHz into a frequency of 17.734475 MHz. Therefore, an oversampling filter having a length of about 16500 orders must be used to give results of sufficient quality.

On the contrary, when the sampling frequency of a PAL composite digital video signal is converted into a sampling frequency which corresponds to a 625/50 component digital video signal, an exclusive oversampling filter of the equivalent circuit size to that of the above-described structure must be constituted in order to convert the rate of the sampling frequency from a frequency of 17.734475 MHz to a frequency of 13.5 MHz. Therefore, each of the structures must include an exclusive circuit as a whole. As a result, there arises a problem in that the circuit structure becomes too complicated and the size becomes too large.

Examples of finite impulse response filters that may be utilised in sample rate convertors are known from European Published Patent Application EP-A-305864, British Published Patent Application GB-A-2180114 and German Published Patent Application DE-A-3605927, DE-A-3605927 discloses the use of parallel FIR filters.

In view of the prior art, an object of the present invention is to provide a sampling rate converting apparatus capable of converting the sampling frequency of a digital signal composed of a first or a second sampling frequency into the second or the first sampling frequency, that is, capable of converting the sampling rate in two opposing directions.

According to the invention there is provided a sampling rate converting apparatus according to claim 1 comprising:

a first finite impulse response filter; and

a second finite impulse response filter connected in parallel with said first finite impulse response filter; characterised by

delay means for varying the delay between filter stages of said first finite impulse response filter.

This structure allows a greater degree of control over the aligning of sample data passing through the filters with the coefficient value applied by the filters.

An embodiment of the sampling rate converting apparatus of the invention will now be described by way of example only, with reference to the accompanying drawings, in which:

Fig. 1 is a block diagram which illustrates a first mode of sampling rate converting apparatus;

Fig. 2 is a characteristic graph which illustrates the Nyquist characteristics of the same;

Fig. 3 is a block diagram which illustrates a second mode of the sampling rate converting apparatus;

Fig. 4 is a block diagram which illustrates the structure of an oversampling finite impulse response filter of one embodiment of the invention;

Fig. 5 is a block diagram which illustrates an equivalent circuit for use in a case where the sampling frequency of a 625/50 component digital video signal is converted into a sampling frequency which corresponds to a PAL composite digital video signal;

Fig. 6 is a timing chart for use to illustrate the supply order of coefficient data items; and

Fig. 7 is a block diagram which illustrates an equivalent circuit for use in a case where the sampling frequency of a PAL composite digital video signal is converted into a sampling frequency which corresponds to a 625/50 component digital video signal utilizing the variable delay between filter stages.

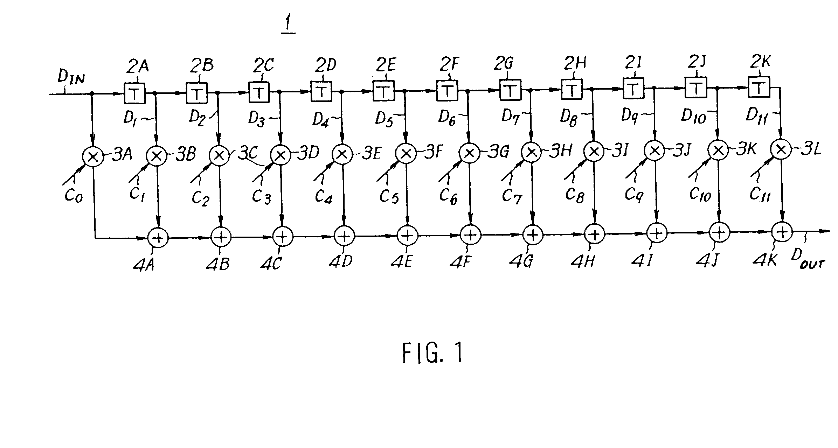

Fig. 1 illustrates a sampling rate converting apparatus capable of converting the sampling frequency in two opposing directions (that is, capable of reversibly converting the same between a first and a second sampling frequencies). For example, the frequency ratio of first and second frequencies $f_1$ and $f_2$ of a digital signal, the sampling ratio of which must be converted, is set to 4:3. Thus, the sampling frequency can reversibly be converted in a direction from digital signal $S_2$ composed of the first sampling frequency $f_1$ toward digital signal $S_2$ composed of the second sampling frequency $f_2$ or in the reverse direction of the above-described direction.

Referring to Fig. 1, in order to obtain desired frequency characteristics including Nyquist characteristics when the sampling frequencies $f_1$ and $f_2$ are converted to each other between the first and the second digital signals $S_1$ and $S_2$, the sampling rate converting apparatus 1 is constituted by an oversampling filter arranged to have a value which is the least common multiple of the sampling frequencies $f_1$ and $f_2$ of the first and the

second digital signals $S_1$ and $S_2$.

The sampling rate converting apparatus 1 is constituted by a so-called FIR (finite impulse response) type digital filter to which the first digital signal $S_1$ is, as input digital signal DIN, supplied when the sampling frequency $f_1$ of the first digital signal $S_1$ is rate-converted into the second sampling frequency $f_2$ to obtain the second digital signal $S_2$.

In a case according to this example (not an embodiment of the invention) the sampling rate converting apparatus 1 comprises a 12-order FIR type digital filter which is operated at an oversampling frequency of $3f_1$ (= $4f_2$). It is composed of a series circuit having 11 flip-flops 2A to 2K each of which has a delay time of T. The delay time T of each of the flip-flops 2A to 2K is determined to a value expressed by the following equation:

$$T = \frac{1}{12 \times 3f_1} = \frac{1}{12 \times 4f_2} \qquad (1)$$

The input digital signal DIN and output digital signals $D_1$ to $D_{11}$ from the corresponding flip-flops 2A to 2K are respectively supplied to weighting means composed of 12 multiplying circuits 3A to 3L.

In a case where the sampling frequency is rate-converted from the first sampling frequency fi into the second sampling frequency f2, the first, the fourth, the seventh and the tenth multiplying circuits 3A, 3D, 3G and 3J are respectively given predetermined coefficients $c_0$, $c_3$, $c_6$ and $c_9$, while the other multiplying circuits 3B, 3C, 3E, 3F, 3H, 3I, 3K and 3L are respectively given coefficients $c_1$, $c_2$, $c_4$, $c_5$, $c_7$, $c_8$, $c_{10}$ and $c_{11}$ the value of each of which is "0".

Thus, the input digital signal DIN supplied to the first, the fourth, the seventh and the tenth multiplying circuits 3A, 3D, 3G and 3J and the output digital signals $D_3$, $D_6$ and $D_9$ from the third, the sixth and the ninth flip-flops 2C, 2F and 2I are respectively multiplied by the predetermined coefficients $c_0$, $c_3$, $c_6$ and $c_9$. Then, the results of all of the multiplications are added to one another by using adder circuits 4A to 4K.

As a result, the input digital signal DIN can be oversampled at an oversampling frequency of $3f_1$ which is three times the first sampling frequency $f_1$ and as well as it can be resampled at a frequency which is 1/4 of the same. Therefore, the second digital signal $S_2$ composed of the second sampling frequency $f_2$ can be transmitted as output digital signal $D_{OUT}$.

On the other hand, when the first digital signal $S_1$ is obtained by converting the sampling rate of the sampling frequency $f_2$ of the second digital signal $S_2$ into the first sampling frequency $f_1$, the second digital signal $S_2$ is supplied as the input digital signal $D_{IN}$.

In this case, the first, the fifth and the ninth multiplying circuits 3A, 3E and 3I are respectively given predetermined coefficients $c_0$, $c_4$ and $c_8$, while the other multiplying circuits 3B, 3C, 3D, 3F, 3G, 3H, 3J, 3K and 3L are respectively given coefficients $c_1$, $c_2$, $c_3$, $c_5$, $c_6$, $c_7$, $c_9$, $c_{10}$ and $c_{11}$ the value of each of which is "0".

Thus, the input digital signal DIN supplied to the first, the fifth and the ninth multiplying circuits 3A, 3E and 3I and the output digital signals $D_4$ and $D_8$ from the fourth and the eighth flip-flops 2D and 2H are respectively multiplied by the predetermined coefficients $c_0$, $c_4$ and $c_8$. Then, the results of all of the multiplications are added to one another by using adder circuits 4A to 4K.

As a result, the input digital signal $D_{IN}$ can be oversampled at an oversampling frequency of $4f_2$ which is four times the second sampling frequency $f_2$ and as well as it can be resampled at a frequency which is 1/3 of the same. Therefore, the first digital signal $S_1$ composed of the first sampling frequency $f_1$ can be transmitted as output digital signal $D_{OUT}$.

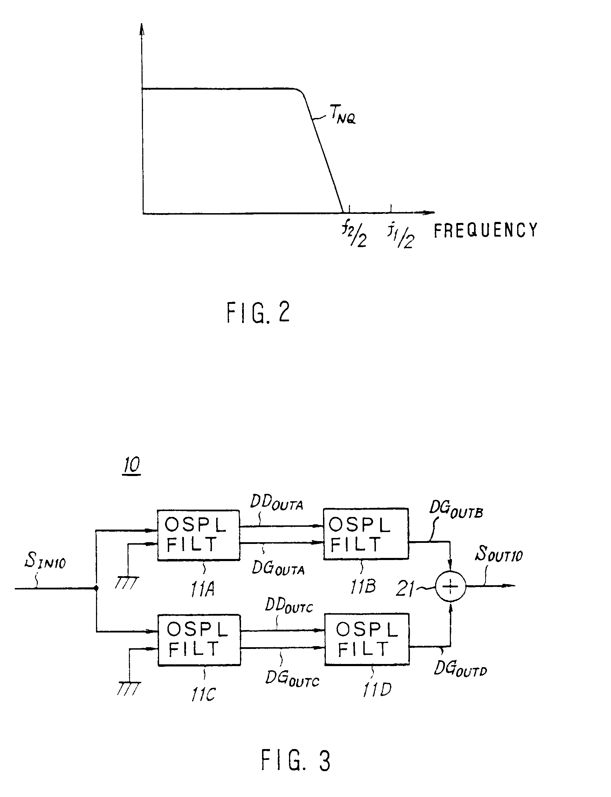

In the structure shown in Fig. 1, in the case where the oversampling rate is converted in either direction, the oversampling frequency has a relationship of a least common multiple of the first and the second sampling frequencies $f_1$ and $f_2$. Therefore, in both cases where the rate is converted from the first sampling frequency $f_1$ into the second sampling frequency $f_2$ and where the rate is converted from the second sampling frequency $f_2$ into the first sampling frequency $f_1$, the sampling rate converting apparatus is, as shown in Fig. 2, able to have the same Nyquist characteristics $T_{NQ}$ at the Nyquist frequencies ($f_1/2$ and $f_2/2$) which are required in the corresponding cases.

The above-described structure is arranged in such a manner that the FIR type digital filters 2A to 2K, 3A to 3L and 4A to 4K which correspond to the least common multiple of the first and the second sampling frequencies $f_1$ and $f_2$ are used to perform the rate conversions in accordance with the oversampling method. Therefore, the sampling rate converting apparatus 1 capable of converting the rate in two opposing directions between the first and the second sampling frequencies $f_1$ and $f_2$ can be realized.

The sampling rate converting apparatus according to a second example rate-converts the sampling frequency of a 625/50 component digital video signal formed in accordance with the D-1 format into a sampling frequency which corresponds to a PAL composite digital video signal formed in accordance with the D-2 format. Furthermore, it rate-converts the sampling frequency of the PAL composite digital video signal into a sampling frequency which corresponds to the 625/50 component digital video signal.

In practice, the sampling frequency fD1 of the 625/50 component digital video signal formed in accordance with the D-1 format relative to the sampling frequency fD2 of the PAL composite digital video signal formed in accordance with the D-2 format is such that a conventional approach to sample rate conversion might require a disadvantageous large filter, e.g. 16500 order.

In contrast, the sample rate converting apparatus according to this embodiment is arranged in such a manner that an oversampling filter of a length of, for example 4554-order may be used for converting in both directions.

That is, in a case where the sampling frequency of the 625/50 component digital video signal is converted into a sampling frequency which corresponds to the PAL composite digital video signal, oversampling is performed at a frequency which is 506 times the sampling frequency $f_{D1}$ (= 13.5 [MHz]) before resampling is performed at a frequency which is 1/414 times the same.

In the contrary case where the sampling frequency of the PAL composite digital video signal is converted into a frequency which corresponds to the 625/50 component digital video signal, oversampling is performed at a frequency which is 414 times the sampling frequency $f_{D2}$ (= 17.734475 [MHz]) before resampling is performed at a frequency which is 1/506 times the same.

As a result, the oversampling frequencies become frequencies of 6381 [MHz] and 7342.04 [MHz]. Therefore, a result can be obtained in that the Nyquist characteristics realized due to the oversampling frequency generate a practically sufficiently small difference of about 7 [%].

Therefore, since the sampling rate converting apparatus according to the second embodiment is arranged to have the Nyquist frequency set to a frequency with which no problem takes place practically. As a result, the rate of the sampling frequency can reliably be converted in the two opposing directions between the 625/50 component digital video signal and the PAL composite digital video signal while further simplifying its structure.

Referring to Fig. 3, reference numeral 10 represents the overall body of a sampling rate converting apparatus for converting the sampling rate in the two opposing directions between the 625/50 component digital video signal and the PAL composite digital video signal in accordance with the above-described principle. According to this embodiment it is formed by combining four oversampling filters 11 (11A, 11B, 11C and 11D) each of which is formed into an integrated circuit.

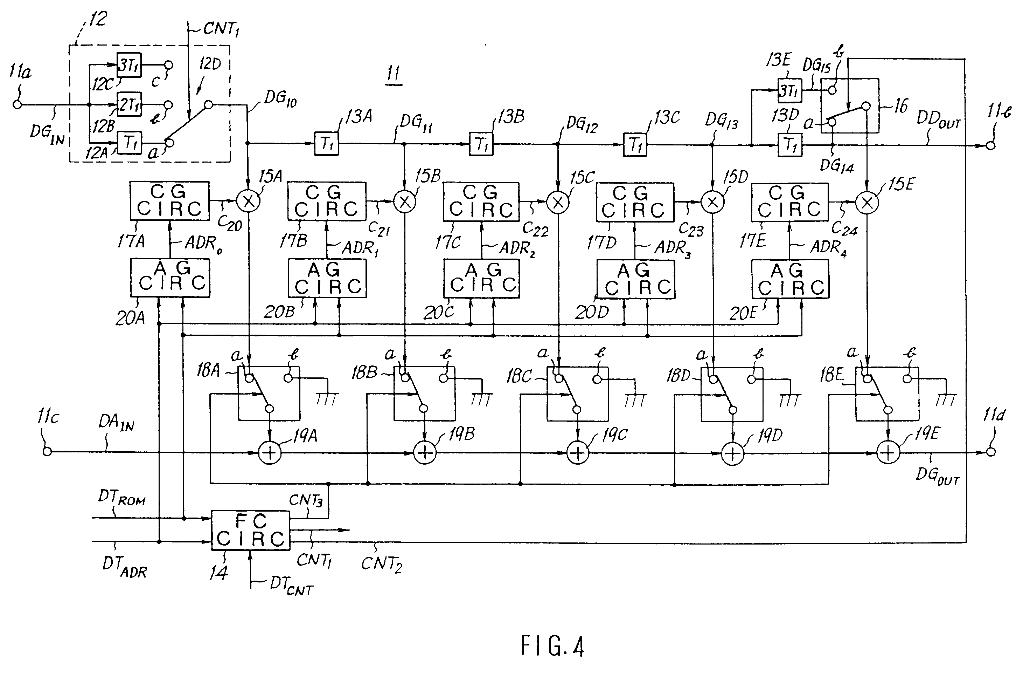

In actual fact, each of the oversampling filters 11 (11A to 11D) are, as shown in Fig. 4, be constituted by the FIR type digital filter the length of which is 5-order or shorter. Digital signal DGIN supplied through a first input terminal 11a thereof is, via a delay input selection circuit 12, supplied to a series circuit comprising the first, the second, the third and the fourth flip-flops 13A, 13B, 13C and 13D each of which has predetermined delay time $T_1$.

The delay input selection circuit 12 has flip-flops 12A, 12B and 12C respectively having delay time $T_1$, delay time $2T_1$ which is two times the former, and delay time $3T_1$ which is three times the same. Therefore, the digital signal $DG_{IN}$ is delayed by each of predetermined time periods when it passes through the flip-flops 12A, 12B and 12C. Then, delay outputs are respectively supplied to a first, a second and a third input terminals a, b and c of a switch circuit 12D.

In the above-described switch circuit 12D, a selection from the first to the third input terminals a to c is made in accordance with selection control signal $CNT_1$ supplied to a filter control circuit 14. As a result, the input digital signal $DG_{IN}$ is delayed by a delay time in accordance with the control operation performed by the filter control circuit 14. Delay digital signal $DG_{10}$ obtained as a result of this is transmitted to the ensuing first flip-flop 13A and is as well as supplied to the first multiplying circuit 15A.

Furthermore, delay digital signals $DG_{11}$, $DG_{12}$ and $DG_{13}$ respectively transmitted from the first, the second and the third flip-flop 13A, 13B and 13C are transmitted to the ensuing second, the third and the fourth flip-flops 13B, 13C and 13D and as well as are supplied to a second, a third and a fourth multiplying circuits 15B, 15C and 15D.

Delay digital signal $DG_{14}$ transmitted from the fourth flip-flop 13D is transmitted via a first output terminal llb as output delay digital signal $DD_{OUT}$ of the overall body of the oversampling filter 11. Furthermore, it is supplied to a first input terminal a of a delay quantity selection circuit 16.

The delay digital signal $DG_{13}$ transmitted from the third flip-flop 13C is also supplied to a flip-flop 13E the delay time of which is $3T_1$, which is three times the delay time of the above-described flip-flop 13D, as well as supplied to this flip-flop 13D. Delay digital signal $DG_{15}$ is supplied to a second input terminal b of the delay quantity selection circuit 16.

The delay quantity selection circuit 16 selects the first input terminal a or the second input terminal b in response to second selection-control signal $CNT_2$ supplied from the filter circuit 14. As a result, either the delay digital signal $DG_{14}$ transmitted from the fourth flip-flop 13D or the delay digital signal $DG_{15}$, which is delayed by the delay time $2T_1$, which is two times the delay time of $DG_{14}$, is supplied to the fifth multiplying circuit 15E.

The above-described multiplying circuits 15A to 15E are respectively supplied with coefficient data $c_{20}$, $c_{21}$, $c_{22}$, $c_{23}$ and $c_{24}$ from first to fifth coefficient generating circuits 17A to 17E each of which is formed into a ROM (read only memory).

As a result, in the first to the fifth multiplying circuits 15A to 15E, the delay digital signals $DG_{10}$, $D_{11}$, $DG_{12}$, $DG_{13}$ and $DG_{14}$ (or $DG_{15}$) and the corresponding coefficient data $c_{20}$, $c_{21}$, $c_{22}$, $c_{23}$ and $c_{24}$ are multiplied together. The results of the multiplications are supplied to the input terminals a of a first to a fifth addition input selection circuits 18A to 18E before they are supplied to first to fifth adder circuits 19A to 19E via their output terminals.

A second input terminal b of each of the first to the fifth addition input selection circuits 18A to 18E is grounded. As a result, when the first input terminals a of the first to the fifth addition input selection circuits 18A to 18E are selected in response to third selection control

signal $CNT_3$ supplied from the filter control circuit 14, addition digital data $DA_{IN}$ supplied from outside through a second input terminal 11c and results of multiplications supplied from the first to the fifth multiplying circuits 15A to 15E are fully added to one another. The results of this are, as output digital signal $DG_{OUT}$, transmitted through a second output terminal 11d.

When the second input terminals b of the first to the fifth addition input selection circuits 18A to 18E are selected in response to the third selection control signal $CNT_3$, data denoting a value of "0" is supplied to the first to the fifth adder circuits 19A to 19E from the first to the fifth addition input selection circuits 18A to 18E. As a result, the addition digital data DAIN supplied from outside is, as it is, transmitted as the output digital signal $DG_{OUT}$.

In the oversampling filter 11 according to this mode, coefficient data $c_{20}$ to $c_{24}$ each of which is composed of 506 coefficients are stored in the storage region of the ROM of each of the first to the fifth coefficient generating circuits 17A to 17E. Each of the coefficients are arranged to be selected and transmitted at the predetermined delay time $T_1$.

In actual fact, in the oversampling filter 11 according to this mode, ROM mode data $DT_{ROM}$ for instructing the read region of the ROMs of the coefficient generating circuits 17A to 17E in accordance with the operational mode and address data $DT_{ADR}$ for instructing the reading timing of the ROM in response to clock signals are supplied to the filter circuit 14 and address generating circuits 20A to 20E.

The address generating circuits 20A to 20E generate read address data $ADR_0$ to $ADR_4$ which correspond to ROM mode data $DT_{ROM}$ and address data $DT_{ADR}$ so as to supply them to the first to the fifth coefficient generating circuits 17A to 17E.

Thus, coefficient data $c_{20}$ to $c_{24}$ written in the coefficient generating circuits 17A to 17E are read in accordance with read address data $ADR_0$ to $ADR_4$ supplied from the corresponding address generating circuits 20A to 20E.

The filter control circuit 14 detects the operation mode which denotes how to control the overall body of the oversampling filter 11 in accordance with ROM mode data $DT_{ROM}$, address data $DT_{ADR}$ and control data $DT_{CNT}$ which has been set and supplied.

As a result, in accordance with the above-described operation mode, the filter control circuit 14 generates first, second and third selection control signals $CNT_1$, $CNT_2$ and $CNT_3$ which respectively control the delay input selection circuit 12, the delay quantity selection circuit 16 and the first to the fifth addition input selection circuits 18A to 18E. As a result, the operation mode for the overall body of the oversampling filter 11 can be controlled.

The bidirectional sampling rate converting apparatus constituted by the four oversampling filters 11 each of which is, as shown in Fig. 4, formed into an integrated circuit. Then, the overall structure will be described.

Referring to Figs. 3 and 4, the first and the second oversampling filters 11A and 11B are longitudinally connected to each other and the third and the fourth oversampling filters 11C and 11D are connected in the same manner. As a result, digital signal $S_{IN10}$, which is the subject of the sampling rate conversion, is, as the input digital signal $DG_{IN}$, supplied to the first input terminals 11a of the first and the third oversampling filters 11A and 11C.

The second input terminals llc of the first and the third oversampling filters 11A and 11C are grounded. As a result, the value "0" is supplied to each of them as the addition digital data $DA_{IN}$.

The output terminals 11b of the first and the third oversampling filters 11A and 11C are respectively connected to the first input terminals 11a of the second and the fourth oversampling filters 11B and 11D. Therefore, output delay digital signal $DG_{OUTA}$ and $DG_{OUTC}$ transmitted from the first and the third oversampling filters 11A and 11C are supplied as input digital signal $DG_{IN}$ for the second and the fourth oversampling filters 11B and 11D.

Furthermore, the output terminals 11d of the first and the third oversampling filters 11A and 11C are respectively connected to the second input terminals 11b of the second and the fourth oversampling filters 11B and 11D. As a result, output digital signals $DG_{OUTA}$ and $DG_{OUTC}$ transmitted from the first and the third oversampling filters 11A and 11C are supplied as addition digital data $DA_{IN}$ for the second and the fourth oversampling filters 11B and 11D.

The longitudinally connected first and the second oversampling filters 11A and 11B and the third and the fourth oversampling filters 11C and 11D, as a whole, constitute the oversampling filter which is composed of the FIR type digital filter and the length of which is 4554-order.

As a result, output digital signals $DG_{OUTB}$ and $DG_{OUTD}$ transmitted from the second and the fourth oversampling filters 11B and llD are supplied to an adder circuit 21. As a result, an additional signal thus-obtained is transmitted as digital signal SOUT10 after the rate has been converted.

As a result of the overall structure, the sampling rate converting apparatus 10 is able to selectively convert the sampling rate from input data in the D-1 format into output data in the D-2 format and as well as from input data in the D-2 format into output data in the D-1 format.

Then, the operation of the sampling rate converting apparatus to convert the rate from the D-1 format into the D-2 format and the operation of the same to convert the rate from the D-2 format into the D-1 format will now be described. The basic structure of the oversampling filter for performing the rate conversion operation employs the portion constituted by longitudinally connecting the upper two oversampling filters 11A and 11B shown in Fig. 3 when the rate conversion from the D-1 format to the D-2 format is performed. On the other hand, the rate conversion from the D-2 format to the D-1 format is performed, a structure constituted by connecting all of the oversampling filters 11A to 11D is employed. The above-described structures are switched over in response to the selection control signals $CNT_1$, $CNT_2$ and $CNT_3$ formed in the above-described filter control circuit 14.

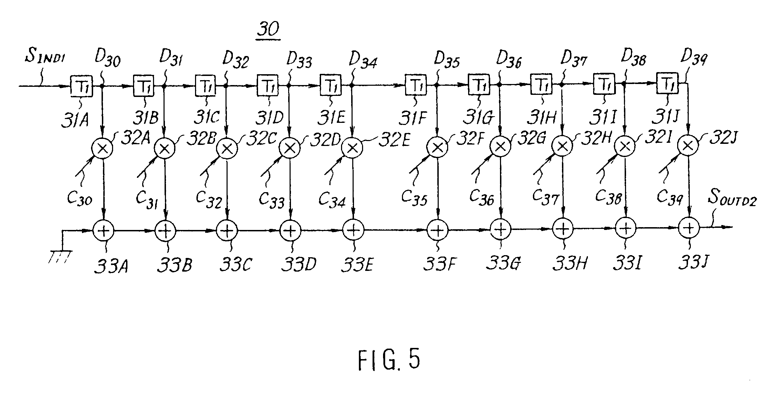

Referring to Fig. 5, reference numeral 30 represents, by an equivalent circuit, the overall body of the sampling rate converting apparatus for use when the rate of the sampling frequency of the 625/50 component digital video signal formed in accordance with the D-1 format is, by using the above-described bidirectional sampling rate converting apparatus 10 (refer to Fig. 3), converted into a sampling frequency which corresponds to the PAL composite digital video signal formed in accordance with the D-2 format.

That is, the first input terminal a of the switch circuit 12D of each delay input selection circuit 12 of the longitudinally-connected first and the second oversampling filters 11A and 11B is selected in response to the first selection control signal CNTi transmitted from the filter control circuit 14.

The first input terminal a of each of the delay quantity selection circuits 16 is selected in response to the second selection control signal $CNT_2$ transmitted from the filter circuit 14. Furthermore, the first input terminal a of each of the first to the fifth addition input selection circuits 18A to 18E is selected in response to the third selection control signal $CNT_3$ transmitted from the filter circuit 14.

On the other hand, the second input terminal b of each of the first to the fifth addition input selection circuits 18A to 18E of the longitudinally connected the third and the fourth oversampling filters 11C and 11D is selected in response to the third selection control signal $CNT_3$ transmitted from the filter control circuit 14.

As described above, the sampling rate converting apparatus 30 is constituted by the FIR type digital filter which controls the third and the fourth oversampling filters 11C and 11D in such a manner that they are not operated, which uses the first and the second oversampling filters IIA and 11B and the length of which is 9 orders (since the final stage multiplication is not performed as described later, the length is 9 orders although the circuit is structured by 10 orders).

Therefore, the transmitted 625/50 component digital video signal $S_{IND1}$ is sequentially supplied to 10 flip-flops 31A to 31J each of which has the predetermined delay time $T_1$. Output digital signals $D_{30}$ to $D_{39}$ from the flip-flops 31A to 31I are supplied to ensuing flip-flops 31B to 31J.

Simultaneously, output digital signals $D_{30}$ to $D_{39}$ from the flip-flops 31A to 31J are multiplied by predetermined coefficients $C_{30}$ to $C_{39}$ in multiplying circuits 32A to 32J before the all of the results of the multiplications are added in adder circuits 33A to 33J. Thus, the sampling frequency of the 625/50 component digital video signal $S_{IND1}$ is rate-converted so that digital signal $S_{OUTD2}$ which corresponds to the sampling frequency of the PAL composite digital video signal is obtained.

The coefficient $c_{39}$ supplied to the final multiplying circuit 32J is determined to be a value of "0", while the other coefficients $c_{30}$ to $c_{38}$ supplied to the other multiplying circuits 32A to 32I use the coefficient data $c_{20}$ to $c_{24}$ composed of 506 coefficients and stored in the ROM region of each of the coefficient generating circuits 17A to 17E (refer to Fig. 4) of the first and the second oversampling filters 11A and 11B at every predetermined delay time $t_1$.

Since the coefficient data $c_{20}$ to $c_{24}$ composed of 506 coefficients are supplied at every predetermined delay time $T_1$ as described above, the 625/50 component digital video signal $S_{IND1}$ is oversampled at a frequency which is 506 times its frequency. Furthermore, it can be resampled at a frequency of 1/414 times of it by supplying a predetermined coefficient which is generated at the timing of the frequency which is 1/414 times the above-described oversampling frequency.

As described above, the sampling rate converting apparatus 30 constitutes a 4554-order (9 orders x 506 times) oversampling filter capable of oversampling the input 625/50 component digital video signal $S_{IND1}$ at a frequency which is 506 times its frequency and resampling the above-described oversampling frequency at a frequency which is 1/414 times the oversampling frequency.

According to the structure shown in Fig. 5, the sampling rate converting apparatus 30 can be realized with which the digital signal $S_{OUTD2}$ which correspond to the sampling frequency of the PAL composite digital video signal can be obtained by rate-converting the sampling frequency of the 625/50 component digital video signal $S_{IND1}$.

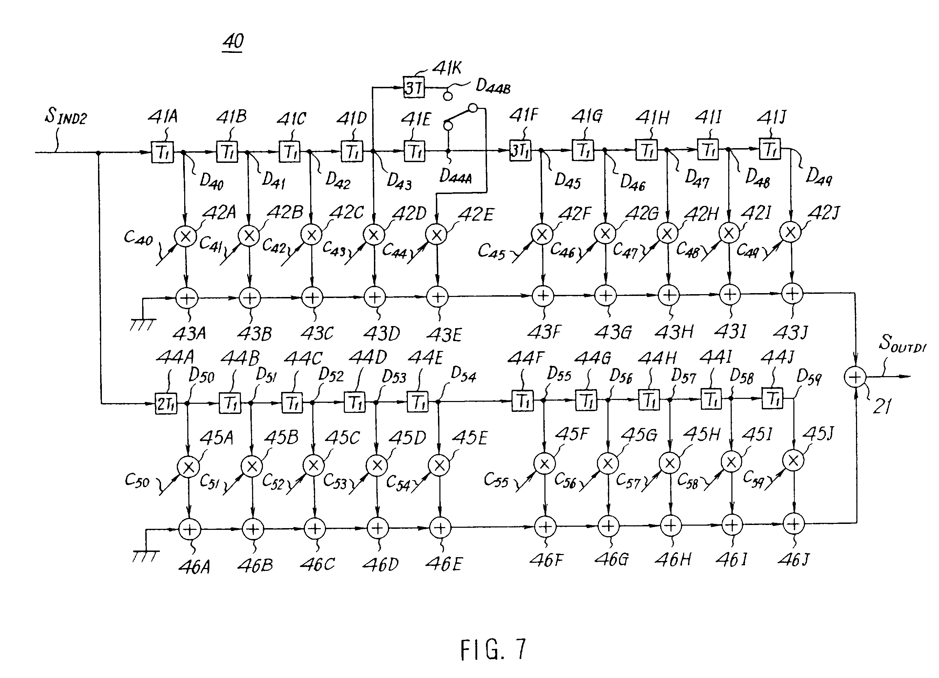

Referring to Fig. 7, reference numeral 40 represents, by an equivalent circuit, the overall body of the sampling rate converting apparatus for use when the rate of the sampling frequency of the PAL composite digital video signal formed in accordance with the D-2 format is, by using the above-described bidirectional sampling rate converting apparatus 10 (refer to Fig. 3), converted into a sampling frequency which corresponds to the 625/50 component digital video signal formed in accordance with the D-1 format.

In the case of the oversampling filter 40, a first input terminal a of the switch circuit 12D of the delay input selection circuit 12 of the first oversampling filter IIA is, as shown in Figs. 3 and 4, selected in response to the first selection control signal $CNT_1$ transmitted from the filter control circuit 14. The first or the second input terminal a or b of the delay quantity selection circuit 16 is switched over at a predetermined timing which corresponds to the second selection control signal $CNT_2$.

The third input terminal c of the switch circuit 12D of the delay input selection circuit 12 of the second oversampling filter 11B is selected in response to the first selection control signal $CNT_1$ transmitted from the filter circuit 14. Furthermore, the first input terminal a of the delay quantity selection circuit 16 is selected in response to the second selection control signal $CNT_2$.

Furthermore, the second input terminal b of the switch circuit 12D of the delay input selection circuit 12 of the third oversampling filter 11C is selected in response to the first selection control signal $CNT_1$ transmitted from the filter control circuit 14. In addition, the first input terminal a of the delay quantity selection circuit 16 is selected in response to the second selection control signal $CNT_2$.

Furthermore, the first input terminal a of the switch circuit 12D of the delay input selection circuit 12 of the fourth oversampling filter 11D is selected in response to the first selection control signal $CNT_1$ transmitted from the filter control circuit 14. In addition, the first input terminal a of the delay quantity selection circuit 16 is selected in response to the second selection control signal $CNT_2$.

The first input terminals a of the first to the fifth addition input selection circuits 18A to 18E of the first to the fourth oversampling filters 11A to 11D are selected in response to the selection control signal $CNT_3$ transmitted from each of the filter control circuits 14.

The sampling rate converting apparatus 40 operates the third and the fourth oversampling filters 11C and 11D at timing which is delayed by the predetermined delay time $T_1$ with respect to the first and the second oversampling filters 11A and 11B. Furthermore, it adds the digital outputs from them so that a 11-order FIR type digital filter is, as the whole, constituted.

Therefore, the PAL composite digital video signal $S_{IND2}$ is, in an equivalent manner, supplied to the longitudinally-connected circuits respectively composed of 10 flip-flops 41A to 41J and 44A to 44J.

Each of the flip-flops 41A to 41J has the predetermined delay time $T_1$ and the output digital signals $D_{40}$ to $D_{49}$ from the corresponding flip-flops 41A to 41J are supplied to the ensuing flip-flops 41B to 41J.

Simultaneously, the output signals $D_{40}$ to $D_{49}$ from the corresponding flip-flops 41A to 41J are multiplied with predetermined coefficients $c_{40}$ to $c_{49}$ in multiplying circuits 42A to 42J before they are added to one another in the adder circuits 43A to 43J. The results of the additions are supplied to the adder circuit 21.

The output digital signal $D_{44}$ to be supplied to a fifth multiplying circuit 42E is selected from an output digital signal $D_{44A}$ transmitted from a fifth flip-flop 41E by the delay quantity selection circuit 16 or the output digital signal $D_{44B}$ of a first flip-flop 41K so as to be supplied.

The output digital signal $D_{44A}$ transmitted from the fifth flip-flop 41E is delayed from the output digital signal $D_{43}$ transmitted from the fourth flip-flop 41D by the predetermined delay time $T_1$.

Output digital signal $D_{44B}$ from an eleventh flip-flop 41K is delayed from the output digital signal $D_{44A}$ transmitted from the fifth flip-flop 41E by delay time $2T_1$ which is two times that of the output digital signal $D_{44A}$.

On the other hand, the first flip-flop 44A of the flip-flops 44A to 44J has the delay time $2T_1$ which is the two times those of others flip-flops. Furthermore, each of the second to the tenth flip-flops 44B to 44J has the predetermined time $T_1$. In addition, output digital signals $D_{50}$ to $D_{59}$ from the corresponding flip-flops 44A to 44J are supplied to the ensuing flip-flops 44B to 44J.

Simultaneously, the output digital signals $D_{50}$ to $D_{59}$ from the corresponding flip-flops 44A to 44J are multiplied with predetermined coefficients $c_{50}$ to $c_{59}$ in multiplying circuits 45A to 45J before they are added to one another in adder circuits 46A to 46J. The results of the additions are supplied to the adder circuit 21.

Thus, the sampling frequency of the PAL composite digital video signal $S_{IND2}$ is rate-converted so that the digital signal $S_{OUTD1}$ having a sampling frequency which corresponds to the 625/50 component digital video signal is obtained.

In the case of this mode, the coefficients $c_{40}$ to $c_{49}$ to be supplied to the upper multiplying circuits 42A to 42J comprise data $c_{20}$ to $c_{24}$ for 506 coefficients stored in the ROM regions of the coefficient generating circuits 17A to 17E (refer to Fig. 4) of the first and the second oversampling filters 11A and 11B at predetermined delay time $T_1$.

The similar structures of the coefficient generating circuits 17A to 17E of the first and the second oversampling filters 11A and 11B are used when the rate conversion from the D-1 format to the D-2 format is performed.

The coefficients respectively allocated to the multiplying circuits 42A to 42J are arranged as follows: as the coefficient c4o to be supplied to the first multiplying circuit 42A, 414 coefficients from the 0-th to 413-th coefficients in the coefficient data $c_{20}$ for 506 coefficients are supplied, while the 414-th to the 505-th coefficients are not supplied but a value of "0" is supplied as an alternative to this.

As the coefficient $c_{41}$ to be supplied to the second multiplying circuit 42B, 322 coefficients from the 0-th to 321-th coefficients in the coefficient data $c_{21}$ for 506 coefficients are supplied, while the 322-th to the 505-th coefficients are not supplied but a value of "0" is supplied as an alternative to this.

As the coefficient $c_{42}$ to be supplied to the third multiplying circuit 42C, 230 coefficients from the 0-th to 229-th coefficients in the coefficient data $c_{22}$ for 506 coefficients are supplied, while the 230-th to the 505-th coefficients are not supplied but a value of "0" is supplied as an alternative to this.

As the coefficient $c_{43}$ to be supplied to the fourth multiplying circuit 42D, 138 coefficients from the 0-th to 137-th coefficients in the coefficient data $c_{23}$ for 506 coefficients are supplied, while the 138-th to the 505-th coefficients are not supplied but a value of "0" is supplied as an alternative to this.

As the coefficient $c_{44}$ to be supplied to the fifth multiplying circuit 42E, 46 coefficients from the 0-th to 45-th coefficients in the coefficient data $c_{24}$ for 506 coefficients and 46 coefficients from the 460-th to 505-th coefficients are supplied, while the 46-th to the 459-th coefficients are not supplied but a value of "0" is supplied as an alternative to this.

As the coefficient $c_{45}$ to be supplied to the sixth multiplying circuit 42F, 138 coefficients from the 368-th to 505-th coefficients in the coefficient data $c_{21}$ for 506 coefficients are supplied, while the 0-th to the 367-th coefficients are not supplied but a value of "0" is supplied as an alternative to this.

As the coefficient $c_{46}$ to be supplied to the seventh multiplying circuit 42G, 230 coefficients from the 276-th to 505-th coefficients in the coefficient data $c_{22}$ for 506 coefficients are supplied, while the 0-th to the 275-th coefficients are not supplied but a value of "0" is supplied as an alternative to this.

As the coefficient $c_{47}$ to be supplied to the eigth multiplying circuit 42H, 322 coefficients from the 184-th to 505-th coefficients in the coefficient data $c_{23}$ for 506 coefficients are supplied, while the 0-th to the 183-th coefficients are not supplied but a value of "0" is supplied as an alternative to this.

As the coefficient $c_{48}$ to be supplied to the ninth multiplying circuit 42I, 414 coefficients from the 92-th to 505-th coefficients in the coefficient data $c_{24}$ for 506 coefficients are supplied, while the 0-th to the 91-th coefficients are not supplied but a value of "0" is supplied as an alternative to this.

All of the coefficients $c_{49}$ to be supplied to the tenth multiplying circuit 42J are determined to be a value of "0".

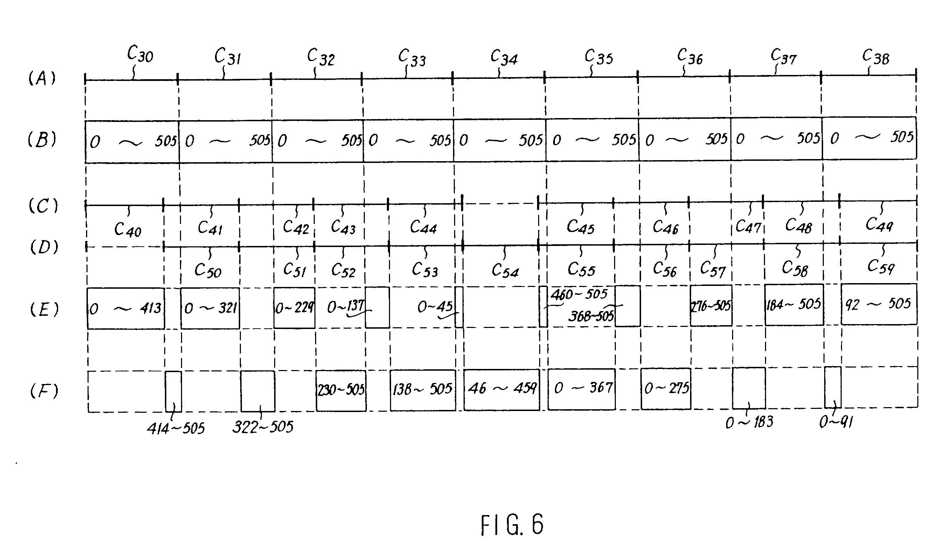

As shown in Figs. 6 (D) and (F), as the coefficients $c_{50}$ to $c_{59}$ to be supplied to the lower multiplying circuits 45A to 45J, the coefficient data $c_{20}$ to $c_{24}$ for 506 coefficients stored in the ROM regions of the coefficient generating circuits 17A to 17E of the third to the fourth oversampling filters 11C and 11D at every predetermined delay time $T_1$ are respectively supplied.

The coefficients to be supplied to each of the multiplying circuits 45A to 45J are as follows:

In actual fact, as the coefficient cso to be supplied to the first multiplying circuit 45A, 92 coefficients from the 414-th to 505-th coefficients in the coefficient data $c_{20}$ for 506 coefficients are supplied, while the 0-th to the 413-th coefficients are not supplied but a value of "0" is supplied as an alternative to this.

As the coefficient $c_{51}$ to be supplied to the second multiplying circuit 45B, 184 coefficients from the 322-th to 505-th coefficients in the coefficient data $c_{21}$ for 506 coefficients are supplied, while the 0-th to the 321-th coefficients are not supplied but a value of "0" is supplied as an alternative to this.

As the coefficient $c_{52}$ to be supplied to the third multiplying circuit 45C, 276 coefficients from the 230-th to 505-th coefficients in the coefficient data $c_{22}$ for 506 coefficients are supplied, while the 0-th to the 299-th coefficients are not supplied but a value of "0" is supplied as an alternative to this.

As the coefficient $c_{53}$ to be supplied to the fourth multiplying circuit 45D, 368 coefficients from the 138-th to 505-th coefficients in the coefficient data $c_{23}$ for 506 coefficients are supplied, while the 0-th to the 137-th coefficients are not supplied but a value of "0" is supplied as an alternative to this.

As the coefficient $c_{54}$ to be supplied to the fifth multiplying circuit 45E, 414 coefficients from the 46-th to 459-th coefficients in the coefficient data $c_{24}$ for 506 coefficients are supplied, while the 0-th to the 45-th and the 460-th to the 505-th coefficients are not supplied but a value of "0" is supplied as an alternative to this.

As the coefficient c55 to be supplied to the sixth multiplying circuit 45F, 368 coefficients from the 0-th to 367-th coefficients in the coefficient data $c_{20}$ for 506 coefficients are supplied, while the 368-th to the 505-th coefficients are not supplied but a value of "0" is supplied as an alternative to this.

As the coefficient $c_{56}$ to be supplied to the seventh multiplying circuit 45G, 276 coefficients from the 0-th to the 275-th coefficients in the coefficient data $c_{21}$ for 506 coefficients are supplied, while the 276-th to the 505-th coefficients are not supplied but a value of "0" is supplied as an alternative to this.

As the coefficient $c_{57}$ to be supplied to the eigth multiplying circuit 45H, 184 coefficients from the 0-th to 183-th coefficients in the coefficient data $c_{22}$ for 506 coefficients are supplied, while the 184-th to the 505-th coefficients are not supplied but a value of "0" is supplied as an alternative to this.

As the coefficient $c_{58}$ to be supplied to the ninth multiplying circuit 45I, 92 coefficients from the 0-th to 91-th coefficients in the coefficient data $c_{23}$ for 506 coefficients are supplied, while the 92-th to the 505-th coefficients are not supplied but a value of "0" is supplied as an alternative to this.

All of the coefficients $c_{59}$ to be supplied to the tenth multiplying circuit 42J are determined to a value of "0".

The timing of each of coefficient data and the flip-flop outputs, which are multiplied by each of the multiplying circuits 42A to 42J and 45A to 45J, must be considered. The reason for this lies in that a deviation takes place between coefficient data and sampling data transferred by the flip-flop because the 506 coefficients stored in each of the coefficient generating circuits are used to rate-convert the D-1 format into the D-2 format and to rate-convert both the D-2 format into the D-1 format. The above-described deviation can be corrected by the oversampling FIR filter of the invention aligning the phase of sampling data to coefficient data.

That is, in the case shown in Fig. 7, the lower oversampling filter is given the delay time of $2T_1$ in the delay input selection circuit 12 as the delay time for its leading flip-flop 44A. The above-described lower oversampling filter multiplies sampling data delayed by 1 clock by coefficient data $c_{50}$ to $c_{59}$. The multiplying circuits 42A to 42D of the upper oversampling filter as it is multiply input sampling data by coefficient data $c_{40}$ to $c_{43}$. In this case, the multiplying circuit 42E must perform the multiplications of the 0-th to the 45-th coefficients and perform multiplications of data obtained by delaying sampling data used in the above-described multiplications by 2 clocks by the 460-th to 505-th coefficients. Therefore, the timing of sampling data supplied to the multiplying circuit 42E is delayed by the delay time $T_1$ or $3T_1$ in the delay quantity selection circuit 16 before it is multiplied by coefficient $c_{44}$.

Coefficient data $c_{45}$ to $c_{49}$ are deviated by 2 clocks from sampling data. Therefore, a further delay time of $2T_1$ is given in the delay input selection circuit 12. It corresponds to the flip-flop 41F.

As described above, the oversampling filter is arranged in such a manner that coefficient data for 506 coefficients are combined in units of 414 coefficients to supply them to the multiplying circuits 42A to 42J and 45A to 45J as coefficient data $c_{40}$ to $c_{49}$ and $c_{50}$ to $c_{59}$ every determined time $T_1$. Therefore, as a whole, the 4554-order (11-order x 414 times) oversampling filter is constituted which is capable of oversampling the supplied PAL composition digital video signal $S_{IND2}$ at a frequency which is 414 times its frequency and as well as resampling it at a frequency which is 1/506 times the oversampling frequency.

According to the structure shown in Fig. 7, the sampling rate converting apparatus 40 can be realized which is capable of obtaining the digital signal $S_{OUTD1}$ which corresponds to the sampling frequency of the 625/50 component digital video signal by rate-converting the sampling frequency of the PAL composite digital video signal $S_{IND2}$.

According to the above-described structure, the oversampling filters formed into the FIR type digital filters each of which is able to select the coefficient to be supplied to the multiplying circuit are combined to one another so as to supply the predetermined coefficient to each of the oversampling filters in accordance with the sampling rate conversion direction between the 625/50 component digital video signal and the PAL composite digital video signal. As a result, a bidirectional sampling rate converting apparatus can be realized which is capable of converting the sampling frequency of the 625/50 component digital video signal into the sampling frequency which corresponds to the PAL composite digital video signal and as well as capable of converting the sampling frequency of the PAL composite digital video signal into the sampling frequency which corresponds to the 625/50 component digital video signal.

The above-described first example is arranged in such a manner that the frequency ratio of the sampling frequencies of the digital signals which are the subject of the rate conversion is determined to be 3:4 and the sampling rate is converted in the two opposing directions by using the oversampling filter the length of which is 12 orders.

A similar effect to that obtainable from the above-described first example can be obtained in a case where the frequency ratio or the sampling frequencies has a simple integer proportional relationship by arranging the structure in such a manner that a sampling filter the length of which corresponds to the least common multiple of the frequency ratio is constituted.

According to the above-described second example the oversampling filter the length of which is 4554 orders is used for approximation from the relationship of the frequency ratio of the sampling frequency of the 625/50 component digital video signal and the sampling frequency of the PAL composite digital video signal so that the sampling rate is converted in the two opposing directions.

The technique can be applied widely when the sampling rate is converted between the sampling frequency of a variety of digital signals and other sampling frequencies in the two opposing directions. In this case, the length of the oversampling filter may be determined in accordance with this.

According to the above-described second example, the sampling rate converting apparatus is constituted by combining four FIR type digital filters each of which is formed into an integrated circuit and the length of each which is five orders.

A variety of structures can be employed to form the sampling rate converting apparatus. For example, a structure which is arranged in such a manner that the overall body is formed into an integrated circuit can be employed. In this case, a similar effect can be obtained to that obtainable from the above-described modes.

**Claims**

**1.** A sampling rate converting apparatus for converting a digital signal which is sampled by a first or a second sampling frequency into said second or said first sampling frequency, the frequency ratio of which holds a simple integral relationship, at said first or said second sampling frequency, said sampling rate converting apparatus comprising:

oversampling filters composed of FIR type digital filters the length of which corresponds to the least common multiple of said frequency ratio of said first and said second sampling frequencies, wherein
said first or said second sampling frequency of said digital signal is converted into said second or said first sampling frequency, said oversampling filters comprising
a first finite impulse response filter (41A-K, 42A-J, 43-A-J); and
a second finite impulse response filter (44A-J, 45A-J, 46A-J) connected in parallel with said first finite impulse response filter; characterised by

delay means (16, 41E, 41K) for varying the delay between filter stages of said first finite impulse response filter.

2. A sampling rate converting apparatus as claimed in claim 1, wherein each of said first finite impulse response filter and said second finite impulse response filter comprises a plurality of filter stages, each filter stage comprising a flip-flop (13A-E) for holding and delaying a sample value, a multiplier (15A-E) for multiplying said sample value by a coefficient value ($C_{29}$ - $C_{24}$) to form a multiplier output, a switch for selecting as a switch output either said multiplier output or a zero value in dependence on a control signal ($CNT_3$), and an adder for forming a stage output by adding said switch output to a stage output from any adjacent preceding stage.

**Patentansprüche**

1. Vorrichtung zum Umsetzen einer Abtastrate zum Umsetzen eines Digitalsignals, das bei einer ersten oder einer zweiten Abtastfrequenz abgetastet worden ist, in die zweite oder die erste Abtastfrequenz, wobei deren Frequenzverhältnis einer einfachen ganzzahligen Beziehung genügt bei der ersten oder der zweiten Abtastfrequenz, wobei die Vorrichtung zum Umsetzen der Abtastrate aufweist:

Übertastungsfilter, bestehend aus FIR-Typ-Digitalfilter, dessen Länge dem kleinsten gemeinsamen Vielfachen des Frequenzverhältnisses der ersten und der zweiten Abtastfrequenz entspricht, wobei

die erste oder die zweite Abtastfrequenz des Digitalsignals in die zweite oder die erste Abtastfrequenz umgesetzt wird, wobei die Übertastungsfilter aufweisen

ein erstes finites Impulsantwortfilter (41A-K, 42A-J, 43-A-J); und

ein zweites finites Impulsantwortfilter (44A-J, 45A-J, 46A-J), das parallel zu dem ersten finiten Impulsantwortfilter geschaltet ist, gekennzeichnet durch

Verzögerungsmittel (16, 41E, 41K) zum Verändern der Verzögerung zwischen Filterstufen des ersten finiten Impulsantwortfilters.

2. Vorrichtung zum Umsetzen einer Abtastrate wie in Anspruch 1 beansprucht, bei der das erste finite Impulsantwortfilter bzw. das zweite finite Impulsantwortfilter mehrere Filterstufen aufweist, wobei jede Filterstufe ein Flipflop (13A-E) zum Halten und Verzögern eines Abtastwertes, einen Multiplizierer (15A-E) zum Multiplizieren des Abtastwertes mit einem Koeffizientenwert ($C_{29}$ - $C_{24}$), um ein Multipliziererausgangssignal zu bilden, einen Schalter zum Wählen entweder des Multipliziererausgangssignals oder eines Nullwerts als Schalterausgangssignal in Abhängigkeit von einem Steuersignal ($CNT_3$) und einen Addierer aufweist zum Bilden eines Stufenausgangssignals durch Addition des Schalterausgangssignals zu einem Stufenausgangssignal von einer benachbarten vorhergehenden Stufe.

**Revendications**

1. Appareil de conversion de cadence d'échantillonnage pour convertir un signal numérique qui est échantillonné par une première ou une seconde fréquence d'échantillonnage dans ladite seconde ou ladite première fréquence d'échantillonnage, dont le rapport de fréquence vérifie une relation intégrale simple, à ladite première ou à ladite seconde fréquence d'échantillonnage, ledit appareil de conversion de cadence d'échantillonnage comprenant :

des filtres de sur-échantillonnage composés de filtres numériques du type FIR dont la longueur correspond au plus petit multiple commun dudit rapport de fréquence de ladite première et de ladite seconde fréquences d'échantillonnage, où

ladite première ou ladite seconde fréquence d'échantillonnage dudit signal numérique est convertie dans ladite seconde ou ladite première fréquence d'échantillonnage, lesdits filtres de sur-échantillonnage comprenant :

un premier filtre à réponse impulsionnelle finie (41A à K, 42A à J, 43A à J) ; et

un second filtre à réponse impulsionnelle finie (44A à J, 45A à J, 46A à J) monté en parallèle avec ledit premier filtre à réponse impulsionnelle finie ;

caractérisé par

un moyen à retard (16, 41E, 41K) pour faire varier le retard entre des étages de filtre dudit premier filtre à réponse impulsionnelle finie.

2. Appareil de conversion de cadence d'échantillonnage selon la revendication 1, dans lequel chacun dudit premier filtre à réponse impulsionnelle finie et dudit second filtre à réponse impulsionnelle finie comprend une pluralité d'étages de filtre, chaque étage de filtre comprenant une bascule (13A à E) pour maintenir et retarder une valeur d'échantillon, un multiplieur (15A à E) pour multiplier ladite valeur d'échantillon par une valeur de coefficient ($C_{20}$ à $C_{24}$) pour former une sortie de multiplieur, un commutateur pour sélectionner comme sortie de commutation soit ladite sortie de multiplieur soit une valeur nulle en fonction du signal de commande ($CNT_3$), et un additionneur pour former une sortie d'étage en additionnant ladite sortie de commutation à une sortie d'étage d'un étage précédent voisin quelconque.

1
D_IN
2A
2B
2C
2D
2E
2F
2G
2H
2I
2J
2K
T
D1
D2
D3
D4
D5
D6
D7
D8
D9
D10
D11
3A
3B
3C
3D
3E
3F
3G
3H
3I
3J
3K
3L
C0
C1
C2
C3
C4
C5
C6
C7
C8
C9
C10
C11
4A
4B
4C
4D
4E
4F
4G
4H
4I
4J
4K
D_OUT

FIG. 1

$T_{NQ}$
$f_2/2$
$f_1/2$
FREQUENCY

FIG. 2

10
$S_{IN10}$
OSPL FILT
11A
$DD_{OUTA}$
$DG_{OUTA}$
OSPL FILT
11B
$DG_{OUTB}$
$S_{OUT10}$
21
OSPL FILT
11C
$DD_{OUTC}$
$DG_{OUTC}$
OSPL FILT
11D
$DG_{OUTD}$

FIG. 3

FIG.4

30
S_IND1
T1
31A
31B
31C
31D
31E
31F
31G
31H
31I
31J
D30
D31
D32
D33
D34
D35
D36
D37
D38
D39
32A
32B
32C
32D
32E
32F
32G
32H
32I
32J
C30
C31
C32
C33
C34
C35
C36
C37
C38
C39
33A
33B
33C
33D
33E
33F
33G
33H
33I
33J
S_OUTD2

FIG. 5

(A)
(B)
(C)
(D)
(E)
(F)
C30
C31
C32
C33
C34
C35
C36
C37
C38
0 ~ 505
C40
C41
C42
C43
C44
C45
C46
C47
C48
C49
C50
C51
C52
C53
C54
C55
C56
C57
C58
C59
0 ~ 413
0 ~ 321
0~229
0~137
0~45
460~505
368~505
276~505
184~505
92 ~ 505
414~505
322~505
230~505
138~505
46 ~ 459
0 ~ 367
0~275
0~183
0~91

FIG. 6

40
SIND2
SOUTD1
21
41A
41B
41C
41D
41E
41F
41G
41H
41I
41J
41K
3T
D44A
D44B
D40
D41
D42
D43
D45
D46
D47
D48
D49
42A
42B
42C
42D
42E
42F
42G
42H
42I
42J
C40
C41
C42
C43
C44
C45
C46
C47
C48
C49
43A
43B
43C
43D
43E
43F
43G
43H
43I
43J
44A
44B
44C
44D
44E
44F
44G
44H
44I
44J
D50
D51
D52
D53
D54
D55
D56
D57
D58
D59
45A
45B
45C
45D
45E
45F
45G
45H
45I
45J
C50
C51
C52
C53
C54
C55
C56
C57
C58
C59
46A
46B
46C
46D
46E
46F
46G
46H
46I
46J

FIG. 7